# EUROPEAN PATENT SPECIFICATION

(11) **EP 2 424 339 B1**
(45) Date of publication and mention of the grant of the patent: **15.11.2017**
(21) Application number: 11178699.2
(22) Date of filing: 24.08.2011
(51) Int. Cl.: H05K 1/18, H05K 3/34

(54) **Electronic component and method of manufacturing the same**
Elektronisches Bauteil und Herstellungsverfahren dafür
Composant électronique et son procédé de fabrication

(30) Priority: 30.08.2010 KR 20100084177
(43) Date of publication of application: 29.02.2012
(73) Proprietor: Samsung Display Co., Ltd., Gyeonggi-do (KR)
(72) Inventor: Choi, Gyeong-Im, 446-711 Gyunggi-Do (KR); Seo, Sung-Gon, 446-711 Gyunggi-Do (KR); Chung, Jae-Mo, 446-711 Gyunggi-Do (KR)
(74) Representative: Walaski, Jan Filip

(56) References cited:
- US-A1- 2004 075 100
- US-A1- 2005 014 302
- US-A1- 2007 081 323
- US-A1- 2009 126 980

## Description

The present invention relates to an electronic component and a method of manufacturing the same, and more particularly, to an electronic component which can be easily miniaturized and made compact, and can be easily manufactured in a simple process, and a method of manufacturing the same.

Recently, due to the miniaturization and light weight of electronic components, techniques for mounting semiconductor devices such as light-emitting diode packages or image sensors, and passive devices such as capacitors or connectors, on a printed circuit board (PCB) have been developed.

When electronic components, for example, key pads of mobile phones, are manufactured, passive devices such as capacitors or connectors are generally mounted on a rear surface of a PCB. However, when key buttons are pressed, light must be emitted to a front surface of a mobile phone. Therefore, a light-emitting diode is generally mounted on a front surface of the PCB.

In a conventional method of manufacturing electronic components, two surface mount technology (SMT) processes are performed with respect to the upper and lower surfaces of a PCB. Thus, a mask for the upper surface and a mask for the lower surface of the PCB are separately required, and this results in increased costs for manufacturing the masks. In addition, since two SMT processes must be performed on the upper and lower surfaces of the PCB, a process of turning over the upper and lower surfaces of the PCB is required. Therefore, the manufacturing process is complicated and takes a long time.

To address the above and/or other problems, the present invention provides an electronic component which can be readily miniaturized and made compact, and which can be manufactured in a simple process, and a method of manufacturing the same.

US2007/0081323 discloses a mounting structure for components forming an LED backlight unit. US2009/0126980 discloses a printed wiring board. US2004/075100 discloses a leadframe, a housing and a radiation-emitting component formed therefrom. Side surfaces of a radiation outlet window in the housing base body are inclined and are used as reflectors for the radiation. US2005/014302 discloses a radiation emitting semiconductor component with a luminescent conversion element, at which the semiconductor body is placed in a recess of the base body. A reflector ring surrounding chip service area is sprayed on the conductor frame. According to the present invention, there is provided an electronic component according to claim 1.

The semiconductor device may be a light-emitting diode package.

The light-emitting diode package may include a protrusion unit disposed at least on an outer circumference thereof, and the protrusion unit is combined with the first surface of the PCB.

At least an adhesive member may be formed on a surface of the protrusion unit facing the first surface of the PCB, or on the first surface of the PCB, so as to combine the light-emitting diode package with the first surface of the PCB.

The adhesive member may include a solder.

The light-emitting diode package may include a package main body and a light-emitting diode chip mounted on the package main body, and the package main body may include a lead frame and a molding unit which fixes the lead frame.

The semiconductor device and the passive device(s) may be combined with the PCB using surface mount technology (SMT).

According to an aspect of the present invention, there is provided a method of manufacturing an electronic component according to claim 6.

The semiconductor device may be a light-emitting diode package.

The light-emitting diode package may include a protrusion unit disposed at least on a portion of an outer circumference thereof, and the step of combining the semiconductor device with the first surface of the PCB may include forming an adhesive member at least on a surface of the protrusion unit facing the first surface of the PCB or on the first surface of the PCB, and soldering the PCB and the light-emitting diode package using the adhesive member.

The semiconductor device and the passive device(s) may be combined only with the first surface of the PCB. The combining of the semiconductor device with the first surface of the PCB and the combining of the passive device(s) with the first surface of the PCB may be performed at the same time.

According to the present invention, an electronic component can be readily miniaturized and compacted, and a process for manufacturing the electronic component is simple.

A more complete appreciation of the invention, and many of the attendant advantages thereof, will be readily apparent as the same becomes better understood by reference to the following detailed description when considered in conjunction with the accompanying drawings, in which like reference symbols indicate the same or similar components, wherein:
FIG. 1 is a schematic cross-sectional view of an electronic component;
FIG. 2 is a schematic cross-sectional view of an electronic component according to an embodiment of the present invention;
FIG. 3 is a magnified view of portion A of FIG. 2;
FIG. 4 is a cross-sectional view of a light-emitting diode package of the electronic component of FIG. 2;
FIG. 5 is a schematic cross-sectional view of a modified version of the electronic component of FIG. 2; and
FIGS. 6 to 9 are cross-sectional views illustrating a method of manufacturing the electronic component according to an embodiment of the present invention.

The present invention will now be described more fully with reference to the accompanying drawings, in which exemplary embodiments of the invention are shown. The invention may, however, be embodied in many different forms and should not be construed as being limited to the embodiments set forth herein. Rather, these embodiments are provided so that this disclosure will be thorough and complete, and will fully convey the concept of the invention to one skilled in the art.

Like reference numerals are used in the drawings to indicate substantially identical structures or components/parts. Since the drawings are schematically drawn, the relative dimensions and ratios in the drawings are exaggerated or reduced for clarity and convenience.

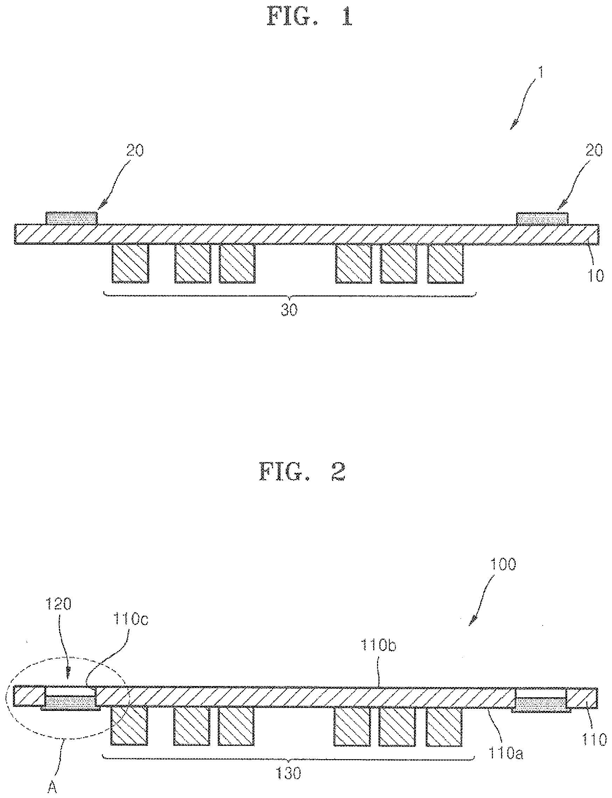

FIG. 1 is a schematic cross-sectional view of an electronic component.

Referring to FIG. 1, the electronic component 1 includes a printed circuit board (PCB) 10, a light-emitting diode package 20, and passive devices 30.

The light-emitting diode package 20 is disposed on an upper surface of the PCB 10. In this way, in order for the light-emitting diode package 20 to be disposed on the upper surface of the PCB 10, after precisely matching the light-emitting diode package 20 on a region of the upper surface of the PCB 10 where the light-emitting diode package 20 must be combined, a surface mount technology (SMT) process is performed by aligning a molded mask with respect to the PCB 10.

Also, the passive devices 30, such as capacitors or connectors, are disposed on a lower surface of the PCB 10. In this case, the PCB 10 is turned over so that the lower surface of the PCB 10 faces upward, and an SMT process is subsequently performed by aligning a mold mask with respect to the PCB 10.

In this way, two SMT processes are performed with respect to the upper and lower surfaces of the PCB 10. Thus, a mask for the upper surface and a mask for the lower surface of the PCB 10 are separately required, and accordingly, costs for manufacturing the masks are increased. In addition, since two SMT processes must be performed on the upper and lower surfaces of the PCB 10, a process of turning over the upper and lower surfaces of the PCB 10 is required. Therefore, the manufacturing process is complicated and takes a long time.

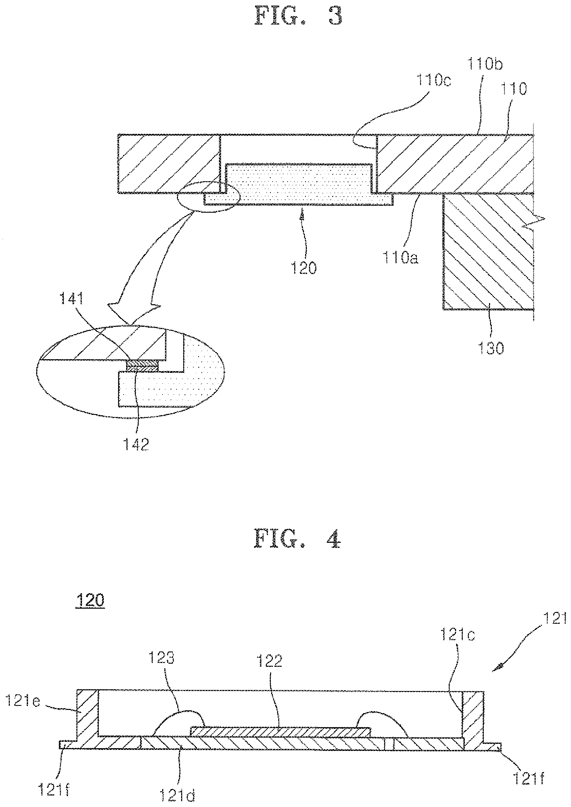

FIG. 2 is a schematic cross-sectional view of an electronic component according to an embodiment of the present invention, FIG. 3 is a magnified view of portion A of FIG. 2, and FIG. 4 is a cross-sectional view of a light-emitting diode package of the electronic component of FIG. 2.

Referring to FIGS. 2 to 4, the electronic component 100 includes a printed circuit board (PCB) 110, a light-emitting diode package 120, and a plurality of passive devices 130.

The PCB 110 constitutes a base unit of the electronic component 100, and semiconductor devices, such as diode packages or image sensors, or the passive devices 130, such as capacitors or connectors, are disposed thereon. The PCB 110 may be a rigid flexible-printed circuit board (RF-PCB). In this regard, it is an aspect of the present invention that a through-hole 110c is formed in at least a portion, and more particularly, in a region of the PCB 110 where the light-emitting diode package 120 is formed, and this will be described in detail below.

The PCB 110 includes a first surface 110a and a second surface 110b. The first surface 110a and the second surface 110b are opposite surfaces of the PCB 110. The first surface 110a is a surface on which the light-emitting diode package 120 and the passive devices 130 are disposed, or mounted, and the second surface 110b is an opposite side relative to the first surface 110a. In this regard, an aspect of the present invention is that the light-emitting diode package 120 and the passive devices 130 are disposed (or mounted) only on the first surface 110a of the PCB 110, and no components are mounted on the second surface 110b of the PCB 110 according to an embodiment of the present invention. This will be described in detail below.

Referring to FIG. 4, which shows the light-emitting diode package 120 of the electronic component 100, the light-emitting diode package 120 according to an embodiment of the present invention includes a package main body 121 and a light-emitting diode chip 122 which is seated on the package main body 121.

The package main body 121 includes a lead frame 121d and a molding unit 121e. The lead frame 121d is formed of a metal having electrical conductivity, and includes an anode lead and a cathode lead separated from each other. The light-emitting diode chip 122 is disposed on a surface of the lead frame 121d. The light-emitting diode chip 122 is electrically connected to the lead frame 121d by a wire 123.

The molding unit 121e fixes the lead frame 121d. The molding unit 121e may be formed of a light resin material and forms a reflection surface 121c. In an illustrative example shown in FIG. 4, the reflection surface 121c is formed by the molding unit 121e. According to the present invention the reflection surface 121c is formed by bending the lead frame 121d.

The molding unit 121e may further include a protrusion unit 121f. Also, a second adhesive member 142 (refer to FIG. 3) may be disposed on the protrusion unit 121f so as to be combined with a first adhesive member 141 (refer to FIG. 3) disposed on the PCB 110 (refer to FIG. 2). In FIG. 4, the protrusion unit 121f protrudes from the molding unit 121e. However, the present invention is not limited thereto. That is, the protrusion unit 121f may protrude from the lead frame 121d. The protrusion unit 121f, or protrusions, therefore provide terminals to allow the light-emitting diode package 120 to be connected to the PCB.

The light-emitting diode package 120 and the passive devices 130 are mounted on a surface of the PCB 110 (see FIG. 2). The surface mount technology (SMT) is a method of mounting surface mounted components (SMC) which can be directly mounted on the surface of a PCB.

In the latter regard, in the electronic component 100 according to an embodiment of the present invention, it is an aspect that the light-emitting diode package 120 and the passive devices 130 are mounted only on one surface of the PCB 110.

As described above with reference to FIG. 1, in a method of mounting the electronic component 1, the light-emitting diode package 20 is disposed on an upper surface of the PCB 10, and the passive devices 30, such as capacitors or connectors, are disposed on a lower surface of the PCB 10. In this case, in the SMT processes, since a mask for the upper surface of the PCB 10 and a mask for the lower surface of the PCB 10 are needed, the cost of manufacturing masks increases. Moreover, since a total of two SMT processes (that is, on the upper and lower surfaces of the PCB 110) must be performed, the manufacturing process is complicated and takes a long time.

In order to address the above problems, an aspect of the present invention is that the electronic component 100 of FIG. 2 includes the PCB 110 having first surface 110a, second surface 110b, and the predetermined through-hole 110c, and the light-emitting diode package 120 is mounted on a region where the through-hole 110c is formed. In this case, the first surface 110a of the PCB 110 and the light-emitting diode package 120 are combined with each other, and at the same time, the passive devices 130 are disposed on the first surface 110a of the PCB 110. That is, the combining of the components is performed only on the first surface 110a of the PCB 110. Combining may describe various methods of connecting the component terminals to one surface of the PCB and/or mounting the component to one surface of the PCB, for example using surface mount technology.

In order to combine the PCB 110 and the light-emitting diode package 120, the first adhesive member 141 and the second adhesive member 142 of FIG. 3 are disposed on the PCB 110 and the light-emitting diode package 120, respectively. The first adhesive member 141 and the second adhesive member 142 include solders, and the PCB 110 and the light-emitting diode package 120 may be combined with each other by soldering them.

In this regard, soldering denotes a process of welding using a solder to constitute a circuit after a part is mounted on the PCB 110. Methods of soldering may be largely divided into two types, flow soldering and reflow soldering. Flow soldering includes a manual soldering method in which a PCB is soaked in a molten solder, and the PCB is subsequently taken out from the molten solder, and an automatic soldering method in which soldering is performed by allowing molten solder to flow onto a PCB which is conveyed by a conveyor. Also, reflow soldering denotes a method of soldering by applying heat to a PCB in an oven after applying a cream solder to the PCB. That is, a soldering process is completed in that, after applying a cream solder to a portion of a PCB to be combined, a component is placed on the PCB, and then the PCB is allowed to pass through a reflow soldering machine.

In this way, after forming the through-hole 110c in the PCB 110, the light-emitting diode package 120 is disposed in the through-hole 110c. Also, the light-emitting diode package 120 and the passive devices 130 are mounted only on the first surface 110a of the PCB 110, and are not mounted on the second surface 110b of the PCB 110. Accordingly, the miniaturization and compactness of the electronic component 100 can be easily achieved, and the manufacturing process can be simplified.

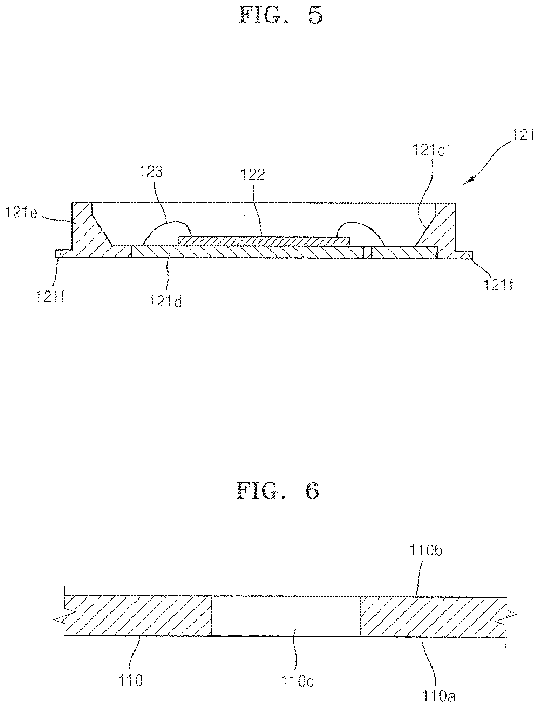

FIG. 5 is a schematic cross-sectional view of a modified version of the electronic component of FIG. 2.

Referring to FIG. 2 and FIG. 5, the electronic component 100 includes a PCB 110, a light-emitting diode package 120, and passive devices 130. The electronic component 100 according to the modified version of the present invention is distinguished from the above embodiment in that a reflection surface 121c' (see FIG. 5) is extended so as to have a predetermined degree angle, which will now be described in detail.

In the case wherein the light-emitting diode package 120 is mounted in the through-hole 110c of the PCB 110 as shown in FIG. 2, the optical extraction efficiency of the light-emitting diode package 120 may be reduced since an optical extraction angle of light emitted from the light-emitting diode package 120 is narrowed. In order to address this problem, in the electronic component 100 according to the modified version of the present invention, the reflection surface 121c' (FIG. 5) is formed so as to have a predetermined angle with respect to the PCB 110 (FIG. 2). Thus, the optical extraction angle of light emitted from the light-emitting diode package 120 is increased. In this way, a reduction of optical extraction efficiency of the light-emitting diode package 120 can be prevented.

A method of manufacturing the electronic component 100, according to an embodiment of the present invention, will now be described.

FIGS. 6 to 9 are cross-sectional views illustrating a method of manufacturing the electronic component according to an embodiment of the present invention.

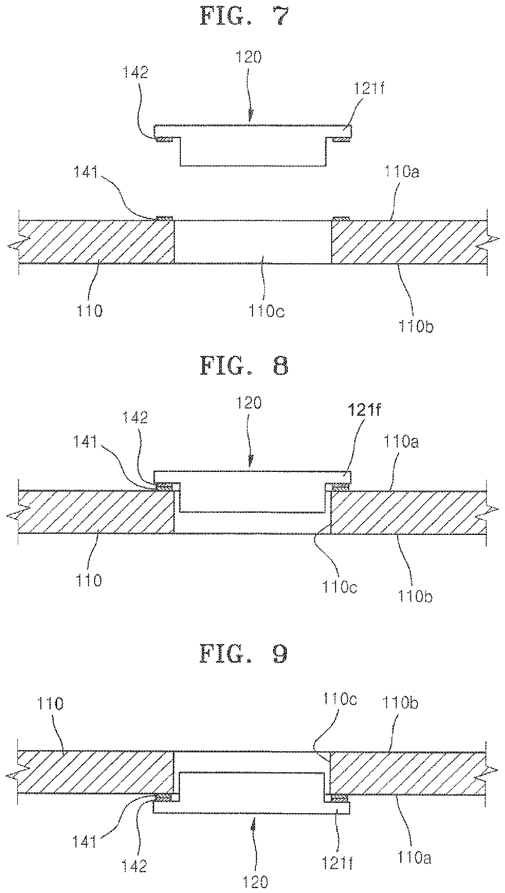

Referring to FIGS. 6 to 9, in the method of manufacturing the electronic component 100, the method includes: forming the through-hole 110c in the PCB 110 (FIG. 6); preparing the light-emitting diode package 120 having the protrusion unit 121f on an outer circumference thereof (FIG. 7); forming an adhesive member 141, 142 at least on the first surface 110a of the PCB 110 and the protrusion unit 121f of the light-emitting diode package 120 (FIGS. 7 and 8); combining the PCB 110 and the light-emitting diode package 120 with each other (FIG. 8); and forming the passive devices 130 on the first surface 110a of the PCB 110 (FIG. 2).

FIG. 6 shows the operation of forming the through-hole 110c in the PCB 110. As shown in FIG. 6, the through-hole 110c, in which the light-emitting diode package 120 (refer to FIG. 2) is mounted, is formed in the PCB 110. The through-hole 110c may be formed using a conventional press process.

FIG. 7 shows the operation of preparing the light-emitting diode package 120 having the protrusion unit 121f on an outer circumference thereof, and forming adhesive members 141 and 142 at least on the first surface 110a of the PCB 110 and on the protrusion unit 121f of the light-emitting diode package 120, respectively.

As shown in FIG. 7, the protrusion unit 121f is formed on an outer circumference of the light-emitting diode package 120. The second adhesive member 142 may be formed on the protrusion unit 121f. In addition, the first adhesive member 141 may be formed on a location of the PCB 110 corresponding to the protrusion unit 121f. At this point, in order to facilitate the combining of the PCB 110 and the light-emitting diode package 120, the PCB 110 may be turned over so that the first surface 110a faces upward and the second surface 110b faces downward, as shown in FIG. 7.

In FIG. 7, it is depicted that the first adhesive member 141 is formed on the first surface 110a of the PCB 110 and the second adhesive member 142 is formed on the protrusion unit 121f of the light-emitting diode package 120. However, the present invention is not limited thereto. That is, the adhesive members may not necessarily be included on both the PCB 110 and the light-emitting diode package 120, but may be included only on one of the PCB 110 and the light-emitting diode package 120.

FIG. 8 shows the operation of combining the PCB 110 and the light-emitting diode package 120. As described above, the first adhesive member 141 and the second adhesive member 142 respectively include solders, and thus the PCB 110 and the light-emitting diode package 120 may be combined with each other by soldering them. At this point, most of the light-emitting diode package 120 is mounted in the through-hole 110c, and thus, miniaturization and compactness of products can be achieved.

Next, although not shown in FIG. 9, the method may further include forming the passive devices 130 on the first surface 110a of the PCB 110. That is, as shown in FIG. 8, in a combined state of the PCB 110 and the light-emitting diode package 120, the passive devices 130 may be disposed on the first surface 110a of the PCB 110 without the need to turn over the PCB 110 in order to change the positions of the first surface 110a and the second surface 110b of the PCB 110. In this way, by allowing the light-emitting diode package 120 and the passive devices 130 to be mounted on the same surface of the PCB 110, the process of manufacturing the electronic component 100 can be simplified.

In the drawings, it is depicted that the combination of the light-emitting diode package 120 with the PCB 110, and the combination of the passive devices 130 with the PCB 110, are sequentially performed. However, the present invention is not limited thereto, that is, the light-emitting diode package 120 and the passive devices 130 may be combined with the PCB 110 through a single soldering operation in a state wherein the light-emitting diode package 120 and the passive devices 130 are disposed together on the PCB 110.

Finally, when the first surface 110a and the second surface 110b of the PCB 110 are turned over, the manufacture of the electronic component 100, as shown in FIG. 9, is completed.

According to the present invention, miniaturization and compactness of an electronic component can be achieved, and the method of manufacturing the electronic component is simplified.

While the present invention has been particularly shown and described with reference to exemplary embodiments thereof, it will be understood by one of ordinary skill in the art that various changes in form and detail may be made therein without departing from the scope of the present invention as defined by the following claims.

## Claims

1. An electronic component (100), comprising:
a printed circuit board PCB (110) having a through-hole (110c);
a semiconductor device mounted in the through-hole and combined with a first surface (110a) of the PCB; and
at least one passive device (30) combined with the first surface of the PCB, wherein the semiconductor device and the passive device(s) are combined only with the first surface of the PCB and are not combined with a second surface (110b) of the PCB opposite the first surface, the semiconductor device comprising a light-emitting diode package (120) which comprises:
a package main body (121) comprising a lead frame (121d) and a molding unit (121e) which fixes the lead frame; and
a light-emitting diode chip (122) mounted on the package main body,
wherein a reflection surface for light emitted from the light-emitting diode chip is formed by bending the lead frame.

2. The electronic component of claim 1, wherein the light-emitting diode package (120) comprises a protrusion unit (121f) on at least an outer circumference of the light-emitting diode package, wherein the protrusion unit is combined with the first surface (110a) of the PCB.

3. The electronic component of claim 2, wherein an adhesive member (141, 142) is formed on one of a surface of the protrusion unit (121f) facing the first surface of the PCB and the first surface of the PCB so as to combine the light-emitting diode package (120) with the first surface of the PCB.

4. The electronic component of claim 3, wherein the adhesive member (141, 142) comprises a solder.

5. The electronic component of any one of the preceding claims, wherein the semiconductor device (120) and the passive devices (130) are combined with the PCB using surface mount technology (SMT).

6. A method of manufacturing an electronic component (100), the method comprising the steps of:
preparing a printed circuit board PCB (110) having a first surface (110a) and a through-hole (110c);
mounting a semiconductor device in the through-hole and combining the semiconductor device with the first surface of the PCB; and
combining passive devices (130) with the first surface of the PCB;
wherein the semiconductor device and the passive devices are combined only with the first surface of the PCB and are not combined with a second surface (110b) of the PCB opposite the first surface, the semiconductor device comprising a light-emitting diode package (120) which comprises:
a package main body (121) comprising a lead frame (121d) and a molding unit (121e) which fixes the lead frame; and
a light-emitting diode chip (122) mounted on the package main body,
wherein a reflection surface for light emitted from the light-emitting diode chip is formed by bending the lead frame.

7. The method of claim 6, wherein the light-emitting diode package comprises a protrusion unit (121f) on at least a portion of an outer circumference of the light-emitting diode package (120), wherein the step of combining the semiconductor device with the first surface (110a) of the PCB comprises:
forming an adhesive member (141, 142) on one of a surface of the protrusion unit facing the first surface of the PCB and the first surface of the PCB; and
soldering the PCB and the light-emitting diode package using the adhesive member.

8. The method of claim 6 or 7, wherein the step of combining the semiconductor device with the first surface (110a) of the PCB and the step of combining the passive devices (130) with the first surface of the PCB are performed at the same time.

## Patentansprüche

1. Elektronisches Bauteil (100), umfassend:
eine Leiterplatte (PCB) (110) mit einem Durchgangsloch (110c);
ein Halbleiterbauelement, montiert in dem Durchgangsloch und vereinigt mit einer ersten Oberfläche (110a) der PCB; und
mindestens ein passives Bauteil (30), vereinigt mit der ersten Oberfläche der PCB, wobei das Halbleiterbauelement und das/die passive/n Bauteil/e nur mit der ersten Oberfläche der PCB vereinigt sind und nicht mit einer zweiten Oberfläche (110b) der PCB gegenüber der ersten Oberfläche vereinigt sind, wobei das Halbleiterbauelement ein Lichtemitterdiodengehäuse (120) umfasst, das umfasst:
einen Gehäusehauptkörper (121), umfassend einen Lead-Frame (121d) und eine Formeinheit (121e), die den Lead-Frame fixiert; und
einen Lichtemitterdioden-Chip (122), montiert auf dem Gehäusehauptkörper,
wobei eine Reflexionsfläche für von dem Lichtemitterdioden-Chip emittiertes Licht durch Biegen des Lead-Frames gebildet ist.

2. Elektronisches Bauteil nach Anspruch 1, wobei das Lichtemitterdiodengehäuse (120) eine Vorsprungseinheit (121f) auf zumindest einem Außenumfang des Lichtemitterdiodengehäuses umfasst, wobei die Vorsprungseinheit mit der ersten Oberfläche (110a) der PCB vereinigt ist.

3. Elektronisches Bauteil nach Anspruch 2, wobei ein Haftglied (141, 142) auf einer Oberfläche der Vorsprungseinheit (121f), die der ersten Oberfläche der PCB zugewandt ist, oder der ersten Oberfläche der PCB ausgebildet ist, um das Lichtemitterdiodengehäuse (120) mit der ersten Oberfläche der PCB zu vereinigen.

4. Elektronisches Bauteil nach Anspruch 3, wobei das Haftglied (141, 142) ein Lötmetall umfasst.

5. Elektronisches Bauteil nach einem der vorangehenden Ansprüche, wobei das Halbleiterbauelement (120) und die passiven Bauteile (130) unter Verwendung der Oberflächenmontagetechnik (SMT) mit der PCB vereinigt sind.

6. Verfahren zur Herstellung eines elektronischen Bauteils (100), wobei das Verfahren die folgenden Schritte umfasst:
Anfertigen einer Leiterplatte (PCB) (110) mit einer ersten Oberfläche (110a) und einem Durchgangsloch (110c);
Montieren eines Halbleiterbauelements in dem Durchgangsloch und Vereinigen des Halbleiterbauelements mit der ersten Oberfläche der PCB; und
Vereinigen von passiven Bauteilen (130) mit der ersten Oberfläche der PCB;
wobei das Halbleiterbauelement und die passiven Bauteile nur mit der ersten Oberfläche der PCB vereinigt werden und nicht mit einer zweiten Oberfläche (110b) der PCB gegenüber der ersten Oberfläche vereinigt werden, wobei das Halbleiterbauelement ein Lichtemitterdiodengehäuse (120) umfasst, das umfasst:
einen Gehäusehauptkörper (121), umfassend einen Lead-Frame (121d) und eine Formeinheit (121e), die den Lead-Frame fixiert; und
einen Lichtemitterdioden-Chip (122), montiert auf dem Gehäusehauptkörper,
wobei eine Reflexionsfläche für von dem Lichtemitterdioden-Chip emittiertes Licht durch Biegen des Lead-Frames gebildet wird.

7. Verfahren nach Anspruch 6, wobei das Lichtemitterdiodengehäuse eine Vorsprungseinheit (121f) zumindest auf einem Abschnitt eines Außenumfangs des Lichtemitterdiodengehäuses (120) umfasst, wobei der Schritt des Vereinigens des Halbleiterbauelements mit der ersten Oberfläche (110a) der PCB umfasst:
Bilden eines Haftglieds (141, 142) auf einer Oberfläche der Vorsprungseinheit, die der ersten Oberfläche der PCB zugewandt ist, oder der ersten Oberfläche der PCB; und
Verlöten der PCB und des Lichtemitterdiodengehäuses unter Verwendung des Haftglieds.

8. Verfahren nach Anspruch 6 oder 7, wobei der Schritt des Vereinigens des Halbleiterbauelements mit der ersten Oberfläche (110a) der PCB und der Schritt des Vereinigens der passiven Bauteile (130) mit der ersten Oberfläche der PCB gleichzeitig durchgeführt werden.

## Revendications

1. Composant électronique (100), comprenant :
une carte de circuits imprimés, PCB, (110) comportant un trou traversant (110c) ;
un dispositif à semi-conducteur monté dans le trou traversant et combiné à une première surface (110a) de la PCB ; et
au moins un dispositif passif (30) combiné à la première surface de la PCB, dans lequel le dispositif à semi-conducteur et le ou les dispositifs passifs ne sont combinés qu' à la première surface de la PCB et ne sont pas combinés à une seconde surface (110b) de la PCB opposée à la première surface, le dispositif à semi-conducteur comprenant un boîtier de diode électroluminescente (120) qui comprend :
un corps principal (121) de boîtier comprenant une grille de connexion (121d) et une unité de moulage (121e) qui fixe la grille de connexion ; et
une pastille (122) de diode électroluminescente montée sur le corps principal de boîtier,
dans lequel une surface de réflexion de lumière émise par la pastille de diode électroluminescente est formée par coudage de la grille de connexion.

2. Composant électronique selon la revendication 1, dans lequel le boîtier de diode électroluminescente (120) comprend une unité en saillie (121f) sur au moins une circonférence extérieure du boîtier de diode électroluminescente, dans lequel l'unité en saillie est combinée à la première surface (110a) de la PCB.

3. Composant électronique selon la revendication 2, dans lequel un élément adhésif (141, 142) est formé sur l'une d'une surface de l'unité en saillie (121f) faisant face à la première surface de la PCB et de la première surface de la PCB de façon à combiner le boîtier de diode électroluminescente (120) à la première surface de la PCB.

4. Composant électronique selon la revendication 3, dans lequel l'élément adhésif (141, 142) comprend une soudure.

5. Composant électronique selon l'une quelconque des revendications précédentes, dans lequel le dispositif à semi-conducteur (120) et les dispositifs passifs (130) sont combinés à la PCB au moyen d'une technologie de montage en surface (SMT).

6. Procédé de fabrication d'un composant électronique (100), le procédé comprenant les étapes consistant à :
préparer une carte de circuits imprimés, PCB, (110) comportant une première surface (110a) et un trou traversant (110c) ;
monter un dispositif à semi-conducteur dans le trou traversant et combiner le dispositif à semi-conducteur à la première surface de la PCB ; et
combiner des dispositifs passifs (130) à la première surface de la PCB ;
dans lequel le dispositif à semi-conducteur et les dispositifs passifs ne sont combinés qu'à la première surface de la PCB et ne sont pas combinés à une seconde surface (110b) de la PCB opposée à la première surface, le dispositif à semi-conducteur comprenant un boîtier de diode électroluminescente (120) qui comprend :
un corps principal (121) de boîtier comprenant une grille de connexion (121d) et une unité de moulage (121e) qui fixe la grille de connexion ; et
une pastille (122) de diode électroluminescente montée sur le corps principal de boîtier,
dans lequel une surface de réflexion de lumière émise par la pastille de diode électroluminescente est formée par coudage de la grille de connexion.

7. Procédé selon la revendication 6, dans lequel le boîtier de diode électroluminescente comprend une unité en saillie (121f) sur au moins une partie d'une circonférence extérieure du boîtier de diode électroluminescente (120), dans lequel l'étape de combinaison du dispositif à semi-conducteur à la première surface (110a) de la PCB consiste à :
former un élément adhésif (141, 142) sur l'une d'une surface de l'unité en saillie (121f) faisant face à la première surface de la PCB et de la première surface de la PCB ; et
souder la PCB et le boîtier de diode électroluminescente au moyen de l'élément adhésif.

8. Procédé selon la revendication 6 ou 7, dans lequel l'étape de combinaison du dispositif à semi-conducteur à la première surface (110a) de la PCB et l'étape de combinaison des dispositifs passifs (130) à la première surface de la PCB sont effectuées en même temps.
